# EUROPEAN PATENT SPECIFICATION

(11) **EP 1 914 284 B1**
(45) Date of publication and mention of the grant of the patent: **16.03.2011**
(21) Application number: 07020227.0
(22) Date of filing: 16.10.2007
(51) Int. Cl.: C09J 7/02, C09J 11/06, H01L 21/00

(54) **Adhesive sheet for processing semiconductor wafers and/or substrates**
Klebefolie zur Verarbeitung von Halbleiterwafern und/oder -substraten
Feuille adhésive pour le traitement de plaquettes et/ou de substrats semi-conducteurs

(30) Priority: 19.10.2006 JP 2006284493
(43) Date of publication of application: 23.04.2008
(73) Proprietor: Nitto Denko Corporation, Ibaraki-shi, Osaka 567-8680 (JP)
(72) Inventor: Shintani, Toshio, Ibaraki-shi Osaka 567-8680 (JP); Yamamoto, Akiyoshi, Ibaraki-shi Osaka 567-8680 (JP); Asai, Fumiteru, Ibaraki-shi Osaka 567-8680 (JP); Hashimoto, Kouichi, Ibaraki-shi Osaka 567-8680 (JP)
(74) Representative: Schaeberle, Steffen

(56) References cited:
- GB-A- 2 184 741
- JP-A- 4 186 832
- JP-A- 5 279 641
- JP-A- 6 049 420
- US-A1- 2004 121 618
- DATABASE WPI Week 200565 Derwent Publications Ltd., London, GB; AN 2005-632769 XP002468751 & JP 2005 229040 A (DENKI KAGAKU KOGYO KK) 25 August 2005 (2005-08-25)

## Description

### BACKGROUND OF THE INVENTION

### 1. Field of the Invention

The present invention relates to an adhesive sheet for processing semiconductor wafers and / or substrates, and more particularly to an adhesive sheet comprising a base film and an adhesive layer containing specific ingredients.

### 2. Background Information

An adhesive sheet for processing semiconductor wafers and / or substrates are conventionally used to secure semiconductor wafers and/or substrats when the semiconductor wafers and/or substrates are diced and expanded, and the semiconductor wafers and/or substrates are then picked up and simultaneously mounted.

In this type of sheet, a UV- and/or radiation-transmittable base film is coated with an adhesive layer that undergoes a polymerization curing reaction by means of UV rays and/or radiation, and the adhesive layer is irradiated with UV rays and/or radiation after the dicing process, causing the adhesive layer to undergo a polymerization curing reaction, whereby the adhesive strength is reduced, allowing the individual pieces such as the semiconductor wafers, chips, or substrates to be picked up.

In an adhesive sheet for semiconductor wafer processing has been proposed as this type of sheet, for example, the adhesive layer comprises a base polymer, a multifunctional urethane acrylate with a molecular weight of 15,000 to 50,000, a polyester plasticizer, and a photopolymerization initiator, where the photopolymerization initiator is included in a proportion of 1 to 50 weight parts per 100 weight parts base polymer (see Japanese Laid-Open Patent Application H06-49420, for example).
The use of multifunctional urethane acrylate oligomers having a molecular weight of about 3,000 to 10,000 for the adhesive layer has also been proposed (see Japanese Laid-Open Patent Application S62-153376, for example).

Recently, however, there have been more wafers with marks printed by laser irradiation to a depth of about 5 to 10 µm on the wafer surface. Additionally, in packages in which substrates with semiconductor chips or the like mounted thereon are sealed with resin, more and more often now the sealed resin surface where the adhesive tape is to be applied has a roughness of about 0.4 to 15 µm, and the substrates have marks printed to a depth of between 25 and 40 µm by the same method as is used for the wafers.

When semiconductors and/or substrates having such a texture are cut, adequate adhesive strength cannot be obtained with conventionally used adhesive sheets because of the inability of the adhering surface to conform sufficiently to the texture, resulting in the flick of chips and packages when the wafers or substrates are cut, with a significant loss of yield. Another disadvantage is that the flicked chips and the like collide with the cutting blade, damaging the blade.

In response, a method has been proposed to prevent chips and the like from being flicked when semiconductor substrates are cut, regardless of the presence or absence of printing, by constructing a sheet using a certain tackifier with a hydroxyl value of 50 KOHmg/g to 150 KOHmg/g, as determined by the JIS K 0070-1992 7.1 neutralization titration method, in an adhesive, for example (see Japanese Laid-Open Patent Application 2005-229040, for example).

Recent trends in environmentally concerned commercialization have led to the adoption of halogen-free flame retardants and the use of stabilizers based on different types of metal soaps than in the past as additives, and to the use of resins, in conjunction with the above, that are different in terms of type, composition, and the like than those used thus far, to maintain the properties of the sealing resin.
Such changes in the sealing resin and the like used for the semiconductor wafers and/or substrates, which are the adherends, have therefore resulted in a new drawback, which is that chips cannot be completely prevented from being flicked during the cutting process simply by using the specific tackifier proposed in Patent document described above.

Additionally, the individual pieces sometimes cannot be picked up in the pick up process if the adhesive strength of the adhesive layer has not been lowered to the desired level after UV irradiation in cases where the sealing resin and/or additives are not suitable for the adherends or the amount of the release agent (such as wax) that is generally applied to the sealing resin surface is insufficient or irregular, or the like. Forcibly picking up the pieces may result in separation in the interior of the sealing resin or a sticky residue over the entire surface of the sealing resin.

### SUMMARY OF THE INVENTION

In view of the foregoing, an object of the present invention is to provide a stable adhesive sheet in which the adhesive strength is lowered to the optimal level during pick up after irradiation with UV rays and/or radiation, leaving no adhesive residue whatsoever, while preserving enough adhesive strength by ensuring that, regardless of the texture on the surface of adherends such as semiconductor wafers and/or substrates, the adhering surface favorably conforms to the texture.

Based on the problems in the prior art, the inventors figure out that there is a need for two mutually conflicting functions in this type of adhesive sheet, where high adhesive strength and cohesive force need to be maintained during adhesion to ensure that chips firmly adhere to the adhesive sheet, and good texture conformability needs to be ensured to prevent the parts from becoming flicked during dicing, whereas the adhesive force needs to be lowered during the pick up process to allow the parts to be readily picked up, without leaving any adhesive residue on the adherends. As a result of extensive research on these two mutually conflicting functions, the present invention was perfected upon the unexpected discovery that the function of a tackifier could be exploited to enhance the adhesive strength, whereas the function of a surfactant could be exploited to lower the adhesive strength during the pick up process, thereby overcoming the above problems without the two functions canceling each other out.
The present invention provides an adhesive sheet for processing semiconductor wafers and / or substrates comprising a UV- and/or radiation-transmittable base film and an adhesive layer that undergoes a polymerization curing reaction by means of UV rays and/or radiation, wherein the adhesive layer comprises at least a tackifier and a surfactant.

The adhesive sheet for processing semiconductor wafers and/or substrats of the present invention can be to lower the adhesive strength to the optimal level during pick up after irradiation with UV rays and/or radiation, while maintaining adhesion with adherends before irradiation with UV rays and/or radiation by ensuring that, regardless of the texture on the surface of adherends such as semiconductor wafers and/or substrates, the adhering surface favorably conforms to the texture with preserving enough adhesive and cohesive strength. This makes it possible to provide a stable adhesive sheet that completely or nearly completely prevents problems such as the flick of semiconductor wafers and/or substrates during the dicing process or the like, with no or virtually no adhesive residue left over on the adhering surfaces of the resulting semiconductor wafers and/or substrates.
The adhesive sheet of the present invention can be utilized in a wide range of any kinds of applications such that it is applied to semiconductor wafers (such as silicon wafer, germanium wafer, gallium arsenide wafer), circuit boards, ceramic substrates, metal substrates, semiconductor packages.

### DETAILED DESCRIPTION OF THE PREFERRED EMBODIMENTS

The adhesive sheet for processing semiconductor wafers and / or substrates of the present invention mainly comprises a base film and an adhesive layer, and the adhesive layer is formed by an adhesive comprising at least a tackifier and a surfactant.
The tackifier in the adhesive layer of the adhesive sheet is normally used to enhance adhesive strength, whereas the surfactant normally has function in lowering adhesive strength in adhesive layers. The combined use of ingredients/agents with this conflicting function in the same adhesive has therefore never been done before. There has been concern that the function of the surfactant would lower the function of the tackifier, particularly in cases where the molecular weight is lower relative to a base polymer constituting the adhesive, as in tackifiers. In light of this function, it seemed unlikely that there would be any function in maintaining and enhancing adhesive strength, due to the cancellation of adhesive strength in cases where the two would be jointly used in the same adhesive, and in fact, the two have not been intentionally combined for such function.
However, it was unexpectedly discovered for the first time that the two could be combined in the present invention so that, at the stage where the adhering function of the tackifier is maximized, only the function of the tackifier is brought about, without a decrease in the adhesive strength, there being virtually no function in reducing the adhesive strength through cleavage of the bonds/crosslinks of the adhesive component by the surfactant because uncured components remain in the components forming the adhesive, whereas at the stage where the adhesive is completely cured and the individual pieces such as the semiconductor wafers and/or substrates are picked up, the function of breaking the bonds/crosslinks of the components that form the adhesive is maximized and the surfactant is concentrated in the interface between the adhesive layer and individual pieces, functioning to separate the two. The adhesive strength is improved without the adhesive strength becoming cancelled, and the conflicting problems of the flick of individual pieces on the one hand and of pick up and sticky residue on the other hand were simultaneously resolved.

The base film used in the present invention is not particularly limited, provided that it may be UV- and/or radiation-transmittable. For example, the material may be at least partially transmittable to radiation such as IR rays, X-rays, and electron beams.
The permeability may be at least about 75%, at least about 80%, and at least about 90%, for example. Examples of the base film include a film made of a polymer or the like, for example, polyester, such as polyvinyl chloride, polyvinylidene chloride, polyethylene terephthalate, polyamide, polyether ether ketone; polyolefins such as very low-density polyethylene, low-density polyethylene, liner polyethylene, medium-density polyethylene, high-density polyethylene, random copolypropylene, block copolypropylene, homopolypropylene, polybutene, polymethylpentene; polyurethane, ethylene-vinyl acetate copolymer, ionomer resin, ethylene-(meth)acrylic acid copolymer, ethylene-(meth)acrylic ester (random, alternating) copolymer, ethylene-butene copolymer, ethylene-hexene copolymer, fluorocarbon polymer, cellulosic resin or crosslinked polymer thereof. The base film may be either a single layer or a multi-layered structure of two or more layers. The thickness of the base film is generally 5 to 400 µm, preferably 20 to 300 µm.

The adhesive layer provided on the base film is not particularly limited, provided that it comprises an adhesive capable of undergoing a polymerization curing reaction by means of UV rays and/or radiation, and includes at least both a tackifier and a surfactant.

The tackifier may preferably have a hydroxyl value of 120 to 230 mg/g, more preferably 120 to 210 mg/g. A hydroxyl value that is too great or too low tends not to result in enough adhesion on the sealing resin before UV irradiation. The adhesive strength also tends not to be lowered to the desired level after UV irradiation, depending on the type of sealing resin or the like on the adhering surface of the adhesive sheet or when there is not enough release agent added to or adhering to the resin surface.

The tackifier may be preferably used in an amount of 0.1 to 70 parts, and 1 to 50 parts per 100 (weight) parts base polymer. Too low a proportion of tackifier will result in less of an increase in the adhesive strength, whereas too much tends to result in a tackifier with less storage stability, making it difficult to achieve long-term stability.

Examples of the tackifier that include hydroxyl groups and have the specified hydroxyl value include terpene phenolic resins, rosin phenolic resins, alkylphenolic resins

Examples of the terpene phenolic resin include alpha-pinene-phenolic reisn, beta-pinene-phenolic reisn, diterpene-phenolic resin, terpenebisphenolic resin or the like. Because terpene phenolic resins can be used to achieve high compatibility with the base polymer, stable quality can be preserved over long periods of time, with virtually no changes in the adhesive tape during tape storage.

The tackifier usually has a lower molecular weight than the base polymer. For example, the molecular weight is in the tens of thousands or less, ten thousands or less, a few thousand or less.

Any ionic or nonionic surfactant can be used. Examples of the surfactant include ester-types, ether types, polyoxyethylene alkyl ethers, polyoxyethylene alkyl phenyl ethers, polyethyleneglycols, carboxylic-types, sulfonic-types, amino acid-types, amine-types. From the standpoint of compatibility, a molecular weight of no more than 200, and no more than 1500 is preferred. However, this limit does no apply when the molecular structure has good affinity for adhesives. Antistatic effects can be provided, particularly when quaternary ammonium salts are used. These can be single types alone or mixtures of two or more.

Among these, ester types are preferred, that is, those including ester compounds or derivatives thereof, preferably with a carbon number of 10 or more. It is possible to both prevent flick and achieve good pick up of adherends with low amounts of a release agent on the surface. Further, ester compounds with an alkyl group of a carbon number of 15 or more are preferred. If the carbon number of the alkyl groups of the compounds is too low, the adhesives containing them will tend to have lower initial adhesive strength. The maximum carbon number is substantially about 50 to 60 in the interests of industrial availability, molecular weight distribution, heat resistance (that is, a maximum melting point of about 110°C), and the like. The melting point of such ester compounds may be preferably at least 40°C to ensure stability during long-term storage at elevated temperatures. As a result, the adhesive properties will be prevented from increasing even when sheets involving the use of the adhesive composition of the invention as the adhesive layer are applied to adherends and stored for long periods of time at elevated temperatures.

Examples of such ester compound include ester compounds (monoesters, diesters, triesters, or the like) of higher alcohols with alkyl groups having a carbon number of at least 10, and preferably at least 15, and acids such as a carboxylic acid, sulfuric acid, sulfurous acid, phosphoric acid, phosphorous acid, or the like. Among these, monoesters, diesters, or trimesters of higher alcohols and phosphoric acid are preferably used. Examples of the higher alcohol include stearyl alcohol (carbon number:18), 1-docosanol (carbon number:22), 1-tetracosanol (carbon number:24), 1-hexacosanol (carbon number:26), 1-octacosanol (carbon number:28), 1-nonacosanol (carbon number:29), myricyl alcohol (carbon number:30), hentriacontanol (carbon number:31), lacceryl alcohol (carbon number:32), cellomelissyl alcohol (carbon number:33), 1-tetratriacontanol (carbon number:34), 1-pentatriacontanol (carbon number:35), 1-heptatriacontanol (carbon number:36), 1-tetratetracontanol (carbon number:44), and the like, for example. Examples of the acid include monocarboxylic acid such as formic acid, acetic acid, benzoic acid; polycarboxylic acid such as oxalic acid, succinic acid, tricarballylic acid. .

Ester compounds of higher alcohols can be produced by heating a higher alcohol and an acid such as a carboxylic acid, sulfuric acid, sulfurous acid, phosphoric acid, or phosphorous acid to reflux in the presence of an acid catalyst such as hydrochloric acid in an organic solvent, and dehydrating the water that is produced. Ester compounds of alcohols and carboxylic acids having alkyl groups with a carbon number of at least 10, and preferably at least 15, can also be used as ester compounds or derivatives thereof.
Other types of commercially available surfactants that will not cause contamination during the semiconductor process can also be selected as desired for use.

In the present invention, the surfactant such as the ester compound or derivative thereof may be blended in an amount of 0.02 to 8 weight parts, and more preferably 0.05 to 2 weight parts, per 100 weight parts base polymer. With an amount that is too low, substantially no effects can be expected when the surfactant is added, whereas adding too much will result in a low initial adhesive strength before UV irradiation, with little hope of the product functioning as an adhesive composition, and the poor compatibility with the adhesive may result in contamination of the adherend surface after being removed.

A commonly used pressure-sensitive adhesive can be employed as the adhesive in the present invention, and may suitably include a compound with UV- and/or radiation-curable functional groups such as carbon-carbon double bonds as a base polymer. Conventionally known base polymers for use in adhesives can be selected as desired for use as the base polymer. Examples that are suitable for use include polymers such as acrylic polymers or elastomers, specifically, acrylic polymers obtained through the polymerization of (meth)acrylic acid or esters thereof and monomers or the like that are copolymerizable with (meth)acrylic acid or esters thereof, and polymers of natural or synthetic rubber. A molecular weight is preferably 300,000 to 1,500,000, or 300,000 to 1,100,000. A molecular weight that is too low tends to result in cutting displacement during the cutting process, while a molecular weight that is too great may make it difficult to achieve compatibility with the tackifier or other additives. The base polymers given in JP 3,797,601A and the Patent Citations described in the prior art may also be used.

Examples of the copolymerizable monomer constituting the base film include hydroxylalkyl esters of (meth)acrylic acid such as hydroxyethyl ester, hydroxybutyl ester, hydroxyhexyl ester; glycidyl (meth)acrylate; monomers containing carboxylic group such as acrylic acid, methacrylic acid, carboxyethyl (meth)acrylate, carboxy pentyl (meth)acrylate, itaconic acid, maleic acid, fumaric acid, crotonic acid; acid anhydride monomers such as maleic anhydride, itaconic anhydride; (meth)acrylamide; (meth)acrylate N-hydroxymethylamide; (meth)acrylate alkylaminoalkylester such as dimethylaminoethyl methacrylate, t-butyl aminoehtyl methacrylate; N-vinylpyrrolidone; acryloyl morpholine; vinyl acetate; styrene; acrylonitrile; N,N-dimethylacrylamide; monomers containing alkoxyl group at side chaine such as methoxyethyl (meth)acrylate, ethoxy (meth)acrylate; . These components can be used alone or as mixture of more than two components.

Regardless of whether the base polymer does or does not have intramolecular carbon-carbon double bonds, it may include any components having carbon-carbon double bonds, monofunctional or multifunctional components, or mixtures thereof. It will preferably include multifunctional and/or UV- (radiation-) curable components to bring about cross linking. Examples of such component include (meth)acrylate oligomers and monomers.
Examples of that include hexanediol di(meth)acrylate, polyethylene glycol di(meth)acrylate, 1,4-butanediol(meth)acrylate, polypropylene glycol di(meth)acrylate, neopentylglycol di(meth)acrylate, pentaerythritol di(meth)acrylate, trimethylolpropane tri(meth)acrylate, pentaerythritol tetra(meth)acrylate, pentaerythritol tri(meth)acrylate, dipentaerythritol monohydroxy penta(meth)acrylate, dipentaerythritol hexa(meth)acrylate, epoxy(meth)acrylate, polyester (meth)acrylate, urethane (meth)acrylate or the like, and various oligomers such as urethane, polyether, polyester, polycarbonate, or polybutadiene oligomers are also included, preferably with a molecular weight in the range of about 100 to 30,000. These components can be used alone or as mixture of more than two components.

Urethane (meth)acrylate oligomers in particular may preferably have 2 to 4, and further 2 acryloyl groups per molecule. These oligomers can be produced, for example, by first reacting between a diisocyanate and polyol in a reactor kept at 60 to 90°C, and then adding a hydroxy (meth)acrylate after the conclusion of the reaction to bring about another reaction.
Examples of diisocyanate include toluene diisocyanate, diphenylmethane diisocyanate, hexamethylene diisocyanate, phenylene diisocyanate, dicyclohexylmethane diisocyanate, xylene diisocyanate, tetramethylxylene diisocyanate, naphthalene diisocyanate, or the like, for example.
Examples of polyol include ethylene glycol, propylene glycol, butanediol, hexanediol, for example.
Examples of hydroxy(meth)acrylate include 2-hydroxyethyl(meth)acrylate, 2-hydroxypropyl(meth)acrylate, for example.

Examples of elastomer used as the base polymer include natural rubbers, synthetic isoprene rubber, styrene-butadiene rubber, styrene-butadiene-styrene block copolymer, styrene-isoprene-styrene block copolymer, butyl rubber, polyisobutylene, polybutadiene, polyvinyl ether, silicone rubber, polyvinyl isobutyl ether, vinyl acetate polymer, chloroprene rubber, nitrile rubber, graft rubber, reclaimed rubber, styrene-ethylene-butylene block copolymer, styrene-propylene-butylene block copolymer, styrene-isoprene copolymer, acrylonitrile-butadiene copolymer, acrylonitrile-acrylate copolymer, methyl-methacrylate-butadiene copolymer, polyisobutylene-ethylene-propylene copolymer, ethylene-vinyl acetate copolymer, or acrylic rubber such as alkyl acrylate copolymer, alkyl acrylate-alkoxy alkyl acrylate copolymer.

A cross linker may be added as desired, particularly when an acrylic polymer is used as the base polymer in the present invention. Cross linkers can bring about three-dimensional cross linking of the base polymer, further enhancing the cohesive strength of the adhesive layer. Examples of the cross linker include any conventional compounds such as polyisocyanate compounds, polyglycidyl compounds, aziridine compounds, melamine compounds polyvalent metal chelate compounds. The proportion in which the cross linker is blended when added may be 0.01 to 10 weigh parts, preferably 0.05 to 5 weigh parts per 100 weight parts base polymer. When the cross linker is blended in a proportion that is too low, the addition of the cross linker will not produce any results, whereas too much will result in free residue in the adhesive layer, contaminating the wafers or semiconductor substrates.

In addition to the above components, the adhesives or the base polymers may optionally comprise at least one conventional additive such as softening agents, antioxidants, curing agents, fillers, UV absorbers, photostabilizers, (photo)polymerization initiators. These additives can be used alone or as mixture of more than two components.

Examples of the softening agent include plasticizer, polybutene, liquid tackifier resins, polyisobutylene lower polymer, polyvinyl isobutyl ether lower polymer, lanolin, depolymerization rubber, processing oil, vulcanized oil or the like, for example.

Examples of the antioxidant include phenol antioxidant such as 2,6-di tert-butyl-4-methylphenol, 1,1-bis-(4-hydroxyphenol) cyclohexane; amine antioxidant such as phenyl β-naphthylamine; benzimidazole antioxidant such as mercaptbenzimidazole; 2,5-di tert-butylhydroquinone.

Examples of the curing agent for the rubber adhesive include isocyanate, sulfur-curable and vulcanization accelerator, polyalkylphenol, organic peroxide, or the like. Examples of the isocyanate include phenylene diisocyanate, tolylene diisocyanate, diphenylmetha diisocyanate, hexamethylene diisocyanate, cyclohexane diisocyanate, or the like. Examples of the sulfur-curable and vulcanization accelerator include thiazole rubber accelerator, sulfenic amide rubber accelerator, thiuram rubber accelerator, dithioate rubber accelerator. Examples of the polyalkylphenol include butyl phenol, octyl phenol, nonyl phenol, or the like. Examples of the organic peroxide include dichromyl peroxide, ketone peroxide, peroxy ketal, hydroperoxide, dialkyl peroxide, peroxyester, peroxy dicarbonate.

Examples of the filler include hydrozincite, titanium oxide, silica, aluminium hydroxide, calcium carbonate, barium sulfate, starch, clay, talc.

The photopolymerization initiator is excited and activated by the irradiation of ultraviolet rays, and generates radicals, thereby curing polyfunctional oligomers by radical polymerization. Examples of the photopolymerization initiator include acetophenone compounds such as 4-phenoxy dichloroacetophenon, 4-t-butyl dichloroacetophenon, diethoxyacetophenon, 2-hydroxy-2-methyl-1-phenyl puropane-1-one, 1-(4-isopropylphenyl)-2-hydroxy-2-methylpropane-1-one, 1-(4-dodecylphenyl)-2-hydroxy-2-methylpropane-1-one, 4-(2-hydroxyethoxy) phenyl)-(2-hydroxy-2-propyl) ketone, 1-hydroxycyclohexyl phenyl ketone, 2-methyl-1-[4-(methyltio)phenyl]-2-morpholinoprophane-1, 2,2-dimethoxy-2-phenylacetophenon; benzoine compounds such as benzoine, benzoine methylether, benzoine ethylether, benzoine isopropylether, benzoine isobutylether; benzophenone compounds such as benzophenone, benzoylbenzoate, benzoyl methyl benzoate, 4-phenyl benzophenone, hydroxyl benzophenone, 4-benzoyl-4'-methyldiphenyl sulfide, 3,3'-dimethyl-4-methoxybenzophenone; thioxanthone compounds such as thioxanthone, 2-chlorthioxanthone, 2-methylthioxanthone, 2,4-dimethyl thioxanthone, isopropyl thioxanthone, 2,4-dichloro thioxanthone; specific photopolymerization initiator such as α-acyloxym ester, acyl phosphine oxide, methylphenyl glyoxylate, benzil, camphorchinone, dibenzosuberone, 2-ethyl anthraquinone, 4',4"-diethlisophthalophenone.

The photopolymerization initiator may be blended in a proportion of 0.1 to 15 weight parts per 100 weight parts base polymer. When the photopolymerization initiator is blended in a proportion that is too low, multifunctional oligomers or monomers will be inadequately cured during the irradiation with UV rays and/or radiation, and the adhesive strength will not be lowered enough. Too much will result in poor heat or fluorescent light stability.

Examples of the polymerization initiator include peroxides such as hydrogen peroxide, benzoyl peroxide, t-butyl peroxide, or the like. One may be preferably used by itself, or it may be combined with a reducing agent and used as a redox type of polymerization initiator. Examples of the reducing agent include ionic salts such as salts of iron, copper, cobalt, sulfite, bisulfite; amines such as triethanol amine; reducing sugar such as aldose, ketose. Also, azo compounds such as 2,2'-azobis-2-methylpropioamidine salt, 2,2'-azobis-2,4-dimethylvaleronitrile, 2,2'-azobis-N,N'-dimethyleneisobutylamidine salt, 2,2'-azobisisobutyronitrile, 2,2'-azobis-2-methyl-N-(2-hydroxyethyl) propionamide may be used. These can be used alone or as mixture of more than two components.

Examples of method for forming the adhesive layer on a base film to produce an adhesive sheet for processing semiconductor wafers or semiconductor substrates include methods in which the components forming the adhesive layer are dissolved as such or by a suitable organic solvent, applied onto the base film by being coated, dispersed, and dried by a heat treatment or the like for 30 seconds to 10 minutes at 80 to 100°C.
The thickness of the adhesive layer in the present invention is not particularly limited, but is preferably about 3 to 35 µm.

The adhesive sheet for processing semiconductor wafers and/or substrates in the present invention can be employed in commonly used methods. For example, semiconductor wafers and/or substrates may be applied and secured on the adhesive sheet of the present invention, and the semiconductor wafers or substrates may then be cut into element pieces (chips) by a rotating circular blade. The pieces are then irradiated with UV rays and/or radiation through the base film side of the adhesive sheet, the adhesive sheet is then radially expanded using a special tool, widening the gaps between the element pieces (chips) to regular intervals, the element pieces (chips) are then poked out by needles or the like, and they are adsorbed or the like by an air pin set or the like, so as to be picked up and simultaneously mounted.
The adhesive sheet of the invention can also be used for a variety of adherends, such as semiconductor wafers, semiconductor substrates, and sealed resin substrates in which one or more chips or the like are individually or integrally sealed with leads and sealing resin or the like. The adherend that is attached is not limited to semiconductors but can be a variety of materials, that is inorganics such as metal, plastic, glass, ceramics, or the like. The adhesive sheet of the invention is particularly suitable for use with objects such as those with an adhering surface having a texture such as a microtexture or what is referred to as a satin finish on the surface, and those with a laser-printed adhering surface, as well as those with an adhering surface that has at least one indentation to a depth of no more than 100 µm (more preferably indentations of no more than about 50 µm, and even more preferably indentations of 0.4 to 40 µm).

The adhesive sheet of the present invention is illustrated in greater detail by, but is not limited to, the following examples and comparative examples. The hydroxyl value of the tackifier was determined by the JIS K 0070-1992 7.1 neutralization titration method.

### Example 1

100 weight parts copolymer (35% of solid content) having weight-average molecular weight of 800000 and copolymerized by methyl acrylate / acrylic acid / 2-ethylhexyl acrylate at weight ratio of 20/10/80, 100 weight parts multifunctional acrylate oligomer (UV-1700, made by Nippon Gohsei), 15 weight parts terpene phenolic resin (YS polyster-N125, made by Yasuhara Chemical Co., Ltd., hydroxyl value: 160 to 170 KOHmg/g) as a tackifier, 0.4 weight parts phosphate surfactant (Phosphenole RL-210, made by Toho Chemical Co., Ltd., carbon number 18 of alkyl group) as a surfactant which is mixed in the form of a solution dissolved in the toluene (heated up to 50°C) so as to be 2% solid content concentration, 1 weight part polyisocyanate compound (Coronate L, made by Nippon Polyurethane Industry Co., Ltd.) as a cross linker, 3 weight parts photopolymerization initiator (Irgacure 651, made by Ciba Specialty Chemicals) was mixed to prepare a resin solution to be an adhesive layer.
The resin solution was applied to a dry thickness of 20 µm on a 38 µm thick polyester film which had undergone silicone release treatment, and was dried for 5 minutes at 120°C.
The 150 µm polyethylene film serving as the base film was then laminated, giving a semiconductor processing sheet.
The resulting semiconductor wafer processing sheet was aged for at least 4 days at 50°C, and was evaluated in the following manner. The results are given in Table 1.

### Example 2

An adhesive sheet was prepared in the same manner as in Example 1 except that the adhesive composition was prepared using the terpene phenolic resin with a hydroxyl value of 200 to 210 KOHmg/g (Mighty Ace K125, made by Yasuhara Chemical Co., Ltd.,) used as the tackifier instead of the terpene phenolic resin with a hydroxyl value of 160 to 170 KOHmg/g. The sheet was evaluated in the following manner.

### Example 3

An adhesive sheet was prepared in the same manner as in Example 1 except that the adhesive composition was prepared using the terpene phenolic resin with a hydroxyl value of 130 to 140 KOHmg/g (Mighty Ace G125, made by Yasuhara Chemical Co., Ltd.,) used as the tackifier instead of the terpene phenolic resin with a hydroxyl value of 160 to 170 KOHmg/g. The sheet was evaluated in the following manner.

### Example 4

An adhesive sheet was prepared in the same manner as in Example 1 except that the adhesive composition was prepared changing to 2 weight part phosphate surfactant of Example 1. The sheet was evaluated in the following manner.

### Example 5

An adhesive sheet was prepared in the same manner as in Example 1 except that the adhesive composition was prepared using 6 weight part alkylphenol nonionic surfactant (Nonion NS-230, made by NOF Corporation) instead of the phosphate surfactant of Example 1, and increasing the amount of the terpene phenolic resin with a hydroxyl value of 160 to 170 KOHmg/g used as the tackifier from 15 to 50 weight parts. The sheet was evaluated in the following manner.

### Example 6

An adhesive sheet was prepared in the same manner as in Example 1 except that the adhesive composition was prepared using 0.02 weight part polyoxyalkylene alkylether (Noygen EA-142, made by Dai-Ichi Kogyou Seiyaku) instead of the phosphate surfactant of Example 1, and decreasing the amount of the terpene phenolic resin with a hydroxyl value of 160 to 170 KOHmg/g used as the tackifier from 15 to 1 weight parts. The sheet was evaluated in the following manner.

### Example 7

An adhesive sheet was prepared in the same manner as in Example 1 except that the adhesive composition was prepared using 0.02 weight part polyoxyalkylene block polymer (Epan 710, made by Dai-Ichi Kogyou Seiyaku) instead of the phosphate surfactant of Example 1, and increasing the amount of the terpene phenolic resin with a hydroxyl value of 160 to 170 KOHmg/g used as the tackifier from 15 to 50 weight parts. The sheet was evaluated in the following manner.

### Example 8

An adhesive sheet was prepared in the same manner as in Example 1 except that the adhesive composition was prepared using 0.05 weight part polyoxyalkylene block polymer (Epan 710, made by Dai-Ichi Kogyou Seiyaku) instead of the phosphate surfactant of Example 1, and increasing the amount of the terpene phenolic resin with a hydroxyl value of 160 to 170 KOHmg/g used as the tackifier from 15 to 60 weight parts. The sheet was evaluated in the following manner.

### Example 9

An adhesive sheet was prepared in the same manner as in Example 1 except that the adhesive composition was prepared using 1.5 weight part polyoxyalkylene block polymer (Epan 710, made by Dai-Ichi Kogyou Seiyaku) instead of the phosphate surfactant of Example 1, and decreasing the amount of the terpene phenolic resin with a hydroxyl value of 160 to 170 KOHmg/g used as the tackifier from 15 to 3 weight parts. The sheet was evaluated in the following manner.

### Comparative Example 1

An adhesive sheet was prepared in the same manner as in Example 1 except that the adhesive composition was prepared using the terpene phenolic resin with a hydroxyl value of 240 to 250 KOHmg/g (YP-90L, made by Yasuhara Chemical Co., Ltd.,) used as the tackifier instead of the terpene phenolic resin with a hydroxyl value of 160 to 170 KOHmg/g. The sheet was evaluated in the following manner.

### Comparative Example 2

An adhesive sheet was prepared in the same manner as in Example 1 except that the adhesive composition was prepared using the terpene phenolic resin with a hydroxyl value of 60 to 70 KOHmg/g (YS polyster T130, made by Yasuhara Chemical Co., Ltd.,) used as the tackifier instead of the terpene phenolic resin with a hydroxyl value of 160 to 170 KOHmg/g. The sheet was evaluated in the following manner.

### Comparative Example 3

An adhesive sheet was prepared in the same manner as in Example 1 except that the adhesive composition was prepared not using the terpene phenolic resin with a hydroxyl value of 160 to 170 KOHmg/g used as the tackifier. The sheet was evaluated in the following manner.

### Comparative Example 4

An adhesive sheet was prepared in the same manner as in Example 1 except that the adhesive composition was prepared not using the phosphate surfactant used as the surfactant. The sheet was evaluated in the following manner.

### Comparative Example 5

An adhesive sheet was prepared in the same manner as in Example 1 except that the adhesive composition was prepared using 0.007 weight part phosphate ester surfactant of Example 1 used as the surfactant, and decreasing the amount of the terpene phenolic resin with a hydroxyl value of 160 to 170 KOHmg/g used as the tackifier from 15 to 1 weight parts. The sheet was evaluated in the following manner.

### Comparative Example 6

An adhesive sheet was prepared in the same manner as in Example 1 except that the adhesive composition was prepared increasing the amount of the terpene phenolic resin with a hydroxyl value of 160 to 170 KOHmg/g used as the tackifier from 15 to 50 weight parts. The sheet was evaluated in the following manner.

### Application of Tape

The adhesive sheets prepared in the examples and comparative examples were applied at a speed of 60 mm/sec and a table temperature of 45°C using a Nitto Seiki M-286N applicator to the sealed resin surface of substrates in which semiconductor chips had been embedded (laser printed to a depth of 15µm in the resin surface). The adhesive strength on the substrates prior to UV irradiation were measured, respectively. Here, an adhesive strength is the value which is measured on an Si-mirror wafer under the conditions of 23 ± 3°C, 90 ° peeling angle and a peeling speed of 300 mm/min (according to ASTM D1000).

### Cutting

The adhesive layer and base film were cut to a cut depth of 90 µm using a DISCO DFG-651 dicer and a resin blade with a blade speed of 38,000 rpm and a blade thickness of 300 µm under conditions involving a speed of 40 mm/sec and a cutting water quantity of 1.5 L/min. The number of flicked packages relative to the 2000 cut packages was determined at this time.

### UV Irradiation to Cure the Adhesive

The cutting process was followed by 30 seconds of UV irradiation from the substrate side using a 20 mW/cm² high pressure mercury lamp to cure the adhesive layer. The adhesive strength to the substrate after UV irradiation was determined.
The product was then cooled to room temperature, the packages were manually released, and the 2000 packages were checked for releasability (release workability) and adhesive residue on the substrate surface.
The results are shown in Table 1 and Table 2.

**Table 1**

| | Examples | | | | | | | | |
|---|---|---|---|---|---|---|---|---|---|
| | 1 | 2 | 3 | 4 | 5 | 6 | 7 | 8 | 9 |
| Adhesive Strength before UV Irradiation (N/20mm) | 6.8 | 5.6 | 6.2 | 4.5 | 4.2 | 4.0 | 5.7 | 7.3 | 4 |
| Chip Flick (number of pieces) | 0 | 0 | 0 | 0 | 0 | 0 | 0 | 0 | 0 |
| Adhesive Strength after UV Irradiation (N/20mm) | 0.40 | 0.51 | 0.38 | 0.18 | 0.1 | 0.4 | 0.43 | 0.47 | 0.21 |
| Release Workability | Easy | | | | | | | | |
| Adhesive Residue | none | | | | | | | | |

**Table 2**

| | Comparative Examples | | | | | |
|---|---|---|---|---|---|---|
| | 1 | 2 | 3 | 4 | 5 | 6 |
| Adhesive Strength before UV Irradiation (N/20mm) | 3.3 | 2.9 | 1.8 | 6.3 | 3.9 | 6.8 |
| Chip Flick (number of pieces) | 50 | 30 | 120 | 0 | 0 | 0 |
| Adhesive Strength after UV Irradiation (N/20mm) | 0.30 | 0.33 | 0.32 | 3.5 | 1.5 | 2.3 |

| | | | | |
|---|---|---|---|---|
| Release Workability | Easy | Difficult | Moderately Difficult | Moderately Difficult |
| Adhesive Residue | none | Occurred at almost whole plane | Occurred at 10% | Occurred at 20% |

This application claims priority to Japanese Patent Application No. 2006-284493.

While only selected embodiments have been chosen to illustrate the present invention, it will be apparent to those skilled in the art from this disclosure that various changes and modifications can be made herein without departing from the scope of the invention as defined in the appended claims. Furthermore, the foregoing descriptions of the embodiments according to the present invention are provided for illustration only, and not for the purpose of limiting the invention as defined by the appended claims and their equivalents. Thus, the scope of the invention is not limited to the disclosed embodiments.

## Claims

1. An adhesive sheet for processing semiconductor wafers and / or substrates comprising a UV- and/or radiation-transmittable base film and an adhesive layer that undergoes a polymerization curing reaction by means of UV rays and/or radiation,
wherein the adhesive layer comprises at least a tackifier and a surfactant, wherein the tackifier has a hydroxyl value of 120 to 230 KOH mg/g.

2. The adhesive sheet according to Claim 1, wherein the tackifier is at least one resin selected from the group consisting of terpene phenolic resins, rosin phenolic resins and alkylphenolic resins.

3. The adhesive sheet according to Claim 2, wherein the tackifier is a terpene phenolic, resin.

4. The adhesive sheet according to Claim 1, wherein the tackifier is used in an amount of 0.1 to 70 parts per 100 weight parts of a base polymer constituting the adhesive layer.

5. The adhesive sheet according to Claim 1, wherein the tackifier has a lower molecular weight than a base polymer constituting the adhesive layer, and the molecular weight is in the tens of thousands or less.

6. The adhesive sheet according to Claim 1, wherein the surfactant has a molecular weight of no more than 2000.

7. The adhesive sheet according to Claim 1, wherein the surfactant is ester compound with a carbon number of 10 or more, or derivatives thereof.

8. The adhesive sheet according to Claim 1, wherein the surfactant is ester compounds with an alkyl group of a carbon number of 15 to 60, or derivatives thereof.

9. The adhesive sheet according to Claim 1, wherein the surfactant is used in an amount of 0.02 to 8 weight parts per 100 weight parts a base polymer constituting the adhesive layer.

10. The adhesive sheet according to Claim 1, wherein the surfactant has a melting point of at least 40°C.

## Patentansprüche

1. Klebefolie zur Verarbeitung von Halbleiterwafern und/oder -substraten, umfassend eine UV- und/oder strahlungsübertragbare Basisfolie und eine Klebeschicht, die einer Polymerisations-Härtungsreaktion mittels UV-Strahlen und/oder Strahlung unterworfen wird, wobei die Klebeschicht zumindest einen Klebrigmacher und ein Netzmittel umfasst, wobei der Klebrigmacher einen Hydroxylwert von 120 bis 230 KOH mg/g aufweist.

2. Klebefolie nach Anspruch 1, wobei der Klebrigmacher zumindest ein Harz, ausgewählt aus der Gruppe bestehend aus Terpen-Phenolharzen, Rosin-Phenolharzen und Alkyl-Phenolharzen, ist.

3. Klebefolie nach Anspruch 2, wobei der Klebrigmacher ein Terpen-Phenolharz ist.

4. Klebefolie nach Anspruch 1, wobei der Klebrigmacher in einer Menge von 0,1 bis 70 Teilen pro 100 Gewichtsanteilen eines Basispolymers, das die Klebeschicht bildet, verwendet wird.

5. Klebefolie nach Anspruch 1, wobei der Klebrigmacher ein geringeres Molekulargewicht als ein Basispolymer, das die Klebeschicht bildet, aufweist, und das Molekulargewicht bei Zehntausenden oder weniger liegt.

6. Klebefolie nach Anspruch 1, wobei das Netzmittel ein Molekulargewicht von nicht mehr als 2000 aufweist.

7. Klebefolie nach Anspruch 1, wobei das Netzmittel eine Esterverbindung mit einer Kohlenstoffzahl von 10 oder mehr oder Derivate davon ist.

8. Klebefolie nach Anspruch 1, wobei das Netzmittel eine Esterverbindung mit einer Alkylgruppe einer Kohlenstoffzahl von 15 bis 60 oder Derivaten davon ist.

9. Klebefolie nach Anspruch 1, wobei das Netzmittel in einer Menge von 0,02 bis 8 Gewichtsanteilen pro 100 Gewichtsanteilen eines Basispolymers, das die Klebeschicht bildet, verwendet wird.

10. Klebefolie nach Anspruch 1, wobei das Netzmittel einen Schmelzpunkt von zumindest 40°C aufweist.

## Revendications

1. Feuillet adhésif destiné à traiter des tranches et/ou des substrats semi-conducteurs comprenant un film de base pouvant transmettre les UV et/ou des radiations et une couche adhésive subissant une réaction de durcissement par polymérisation au moyen de rayons UV et/ou de radiations,
la couche adhésive comprenant au moins un agent donnant du collant et un tensioactif, dans laquelle l'agent donnant du collant a un indice d'hydroxyle de 120 à 230 mg de KOH/g.

2. Feuillet adhésif selon la revendication 1, dans lequel l'agent donnant du collant est au moins une résine choisie dans le groupe comprenant des résines phénoliques terpéniques, des résines phénoliques de colophane et des résines alkylphénoliques.

3. Feuillet adhésif selon la revendication 2, dans lequel l'agent donnant du collant est une résine phénolique terpénique.

4. Feuillet adhésif selon la revendication 1, dans lequel l'agent donnant du collant est utilisé en une quantité allant de 0,1 à 70 parties pour 100 parties en poids d'un polymère de base constituant la couche adhésive.

5. Feuillet adhésif selon la revendication 1, dans lequel l'agent donnant du collant a un poids moléculaire plus faible que celui d'un polymère de base constituant la couche adhésive, et le poids moléculaire est inférieur ou égal à quelques dizaines de milliers.

6. Feuillet adhésif selon la revendication 1, dans lequel le tensioactif a un poids moléculaire inférieur à 2 000.

7. Feuillet adhésif selon la revendication 1, dans lequel le tensioactif est un composé ester ayant un nombre de carbones supérieur ou égal à 10, ou des dérivés de celui-ci.

8. Feuillet adhésif selon la revendication 1, dans lequel le tensioactif consiste en des composés ester portant un groupe alkyle ayant un nombre de carbones allant de 15 à 60, ou des dérivés de ceux-ci.

9. Feuillet adhésif selon la revendication 1, dans lequel le tensioactif est utilisé en une quantité allant de 0,02 à 8 parties en poids pour 100 parties en poids d'un polymère de base constituant la couche adhésive.

10. Feuillet adhésif selon la revendication 1, dans lequel le tensioactif a un point de fusion d'au moins 40°C.
